(19) **Europäisches Patentamt**
**European Patent Office**
**Office européen des brevets**

(11) **EP 3 767 845 B1**

(12) **EUROPEAN PATENT SPECIFICATION**

(45) Date of publication and mention
of the grant of the patent:
**26.07.2023 Bulletin 2023/30**

(21) Application number: **18914040.3**

(22) Date of filing: **21.12.2018**

(51) International Patent Classification (IPC):
**G01R 29/08** (2006.01)       **H04B 17/12** (2015.01)
**H04B 7/0413** (2017.01)

(52) Cooperative Patent Classification (CPC):
**G01R 29/0892; H04B 17/12;** H04B 7/0413

(86) International application number:
**PCT/CN2018/122664**

(87) International publication number:
**WO 2019/196499 (17.10.2019 Gazette 2019/42)**

(54) **TEST METHOD AND TRANSMITTING APPARATUS**

TESTVERFAHREN UND SENDEVORRICHTUNG

PROCÉDÉ D'ESSAI ET APPAREIL ÉMETTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.04.2018 CN 201810326946**

(43) Date of publication of application:
**20.01.2021 Bulletin 2021/03**

(73) Proprietor: **HUAWEI TECHNOLOGIES CO., LTD.
Shenzhen, Guangdong 518129 (CN)**

(72) Inventors:
• **HAO, Bo**
**Guangdong 518129 (CN)**

• **LI, Xiaopeng**
**Guangdong 518129 (CN)**
• **ZHAO, Xubo**
**Guangdong 518129 (CN)**

(74) Representative: **MERH-IP Matias Erny Reichl
Hoffmann
Patentanwälte PartG mbB
Paul-Heyse-Strasse 29
80336 München (DE)**

(56) References cited:
**CN-A- 101 911 655       CN-A- 101 911 655
CN-A- 102 749 529       CN-A- 103 777 180
CN-A- 106 850 495       CN-A- 108 988 963
US-A1- 2015 268 325**

# Description

## TECHNICAL FIELD

This application relates to the field of wireless communications, and in particular, to a test method, a transmit device, a test device, and a test system.

## BACKGROUND

Multiple-input multiple-output (Multiple-Input Multiple-Output, MIMO) is a communications technology in which a plurality of transmit antennas and a plurality of receive antennas are separately used at a transmit end and a receive end, so that a signal is transmitted and received by using the plurality of antennas at the transmit end and the receive end. An existing MIMO indicator test system includes a far-field test system. In the far-field test system, a distance between a transmit antenna array and a receive antenna cannot be excessively short, and is limited by a distance threshold. The transmit antenna array and the receive antenna need to be placed in an electromagnetic anechoic chamber used to isolate an external electromagnetic signal. Therefore, a length of the electromagnetic anechoic chamber needs to be greater than the distance between the transmit antenna array and the receive antenna. Only when a distance threshold condition is met, signals transmitted by different transmit antennas can be in-phase superposed, at the receive antenna, and the receive antenna can receive a compound signal that can meet a measurement requirement. If this condition is not met, an obtained signal metric value has a very large error, and a test requirement cannot be met and a signal test cannot be accurately performed.

Document CN 101 911 655 A generally relates to a communication terminal including first and second transmitters, which are coupled to produce respective first and second Radio Frequency (RF) signals that are phase-shifted with respect to one another by a beamforming phase offset, and to transmit the RF signals toward a remote communication terminal. The terminal includes a reception subsystem including first and second receivers and a phase correction unit. The first and second receivers are respectively coupled to receive third and fourth RF signals from the remote communication terminal. The phase correction unit is coupled to produce, responsively to the third and fourth RF signals, a phase correction for correcting an error component in the beamforming phase offset.

Document CN 102 749 529 A generally discloses a compact range antenna measuring system which comprises a feed source which is arranged in a microwave anechoic chamber and a planar wave generation unit formed by a plurality of meta-material layers which are overlapped with one another, wherein each meta-material layer comprises a substrate and a plurality of artificial hole micro-structures on the substrate; and electromagnetic waves generated by the feed source are converted into planar electromagnetic waves after passing through the planar wave generation unit.

## SUMMARY

In view of this, this application provides a MIMO signal test method and apparatus, to resolve a prior-art problem that a signal test cannot be accurately performed when a distance between a transmit antenna array and a receive antenna is less than a distance threshold. In particular, there are provided test methods and a transmit device, having the features of respective independent claims. The dependent claims relate to embodiments.

According to a first aspect, a test method is provided. The method includes: transmitting, by a transmit device, N signal sequences by using a transmit antenna array; obtaining, from a test device, a phase offset that is of each signal sequence in the N signal sequences and that is generated after the signal sequence passes through a channel; adjusting an initial test signal based on the phase offset that is of each signal sequence and that is generated after the signal sequence passes through the channel, to obtain a target test signal in-phase superposed at the test device, where the target test signal includes a plurality of signal sequences obtained by separately performing phase adjustment on the initial test signal based on the phase offset that is of each signal sequence and that is generated after the signal sequence passes through the respective channel; and transmitting the target test signal by using the transmit antenna array. The N signal sequences are orthogonal to each other, and N is a positive integer greater than 1. The transmit antenna array includes N transmit antenna units. Specifically, the transmit device transmits the N signal sequences by using the N transmit antenna units in the transmit antenna array, and the N transmit antenna units are in a one-to-one correspondence with the N signal sequences. In particular, an array aperture of the transmit antenna array denoted as D, a distance between the transmit antenna array and a receive antenna denoted as d and a wavelength of the target test signal denoted as $\lambda$ satisfy a condition of: $d < 2D^2 / \lambda$.

A phase is a physical quantity that reflects a status of an antenna signal at any moment. At a moment t, the phase of the antenna signal is a location of the moment t in a signal period. In this way, the transmit device performs phase adjustment on the initial test signal, and the phase-adjusted initial test signal can be in-phase superposed at a receive antenna in a short-distance condition, so that a valid signal that can meet a test requirement can be received, and a more accurate signal metric of the transmit device can be calculated.

In a possible implementation, the phase offset, the initial test signal, and a signal sequence of the target test signal meet the following formula: $S_{tk} = S_t e^{-j\Delta\varphi_k}$, where $S_{tk}$ is a $k^{th}$ signal sequence in the target test signal, $S_t$ is the initial test signal, $\Delta\varphi_k$ is a phase offset that is of the $k^{th}$ signal sequence and that is generated after the $k^{th}$ signal sequence passes through a channel, and k is not greater than N. In this way, a phase offset of each antenna signal may be calculated, and after phase adjustment is performed on all antenna signals according to the foregoing calculation result, all antenna signals can be in-phase superposed at the receive antenna.

In another possible implementation, the method further includes: obtaining, by the transmit device from the test device, an attenuation amplitude that is of each signal sequence and that is generated after the signal sequence passes through a channel; and adjusting the initial test signal based on the phase offset and the attenuation amplitude that are of each signal sequence and that are generated after the signal sequence passes through the channel, to obtain the target test signal. According to this implementation, not only phase adjustment can be performed on the test signal, but also an attenuation amplitude of the test signal can be adjusted. Therefore, a more accurate signal metric of the transmit device can be calculated by eliminating an error caused by attenuation of the test signal, and a test application scope is expanded.

In another possible implementation, the phase offset, the attenuation amplitude, the initial test signal, and a

$$\mathbf{S_{tk}} = \frac{1}{\alpha_k}\mathbf{S_t}e^{-j\Delta\varphi_k}$$

signal sequence of the target test signal meet the following formula: , where $S_{tk}$ is a $k^{th}$ signal sequence in the target test signal, $\mathbf{S_t}$ is the initial test signal, $\alpha_k$ is an attenuation amplitude that is of the $k^{th}$ signal sequence and that is generated after the $k^{th}$ signal sequence passes through a channel, $\Delta\varphi_k$ is a phase offset that is of the $k^{th}$ signal sequence and that is generated after the $k^{th}$ signal sequence passes through a channel, and k is not greater than N. In this way, a method for calculating a phase offset and an attenuation amplitude is provided, and all antennas can be in-phase superposed at the receive antenna.

In another possible implementation, the N signal sequences are N signal sequences selected from an orthogonal sequence, and the orthogonal sequence is an m sequence, a Golden sequence, a Walsh sequence, a LAS sequence, a Golay sequence, or a Kasami sequence.

In another possible implementation, the transmitting, by a transmit device, N signal sequences by using a transmit antenna array includes: simultaneously transmitting, by the transmit device, the N signal sequences by using the transmit antenna array; and the transmitting, by the transmit device, the target test signal by using the transmit antenna array includes: simultaneously transmitting, by the transmit device, the target test signal by using the transmit antenna array, where the target test signal includes the N signal sequences.

It can be learned from the foregoing descriptions, the embodiments of this application have the following advantages:

After the N signal sequences are transmitted by using the N transmit antennas, the phase offset of each signal sequence can be determined based on the first signal corresponding to the N signal sequences, and then phase adjustment is performed on the initial test signal based on the phase offset. In this way, the test signal after phase adjustment can be in-phase superposed at the receive antenna, to obtain a valid signal and further calculate the signal metric of the transmit device. Therefore, an accurate test signal can be implemented without being limited by a distance threshold, and costs of constructing an electromagnetic anechoic chamber can be controlled.

**BRIEF DESCRIPTION OF DRAWINGS**

FIG. 1 is a schematic diagram of a MIMO test system;
FIG. 2 is a schematic diagram of a transmit antenna array and a receive antenna in an electromagnetic anechoic chamber;
FIG. 3 is a flowchart of a test method according to an embodiment of this application;
FIG. 4 is a schematic diagram of a transmit device according to an embodiment of this application;
FIG. 5 is a schematic diagram of a test device according to an embodiment of this application;
FIG. 6 is a schematic diagram of a MIMO test system according to an embodiment of this application;
FIG. 7 is another schematic diagram of a structure of a transmit device according to an embodiment of this application; and
FIG. 8 is another schematic diagram of a structure of a test device according to an embodiment of this application.

## DESCRIPTION OF EMBODIMENTS

A method for testing a transmit device provided in this application is mainly applied to a MIMO test system.

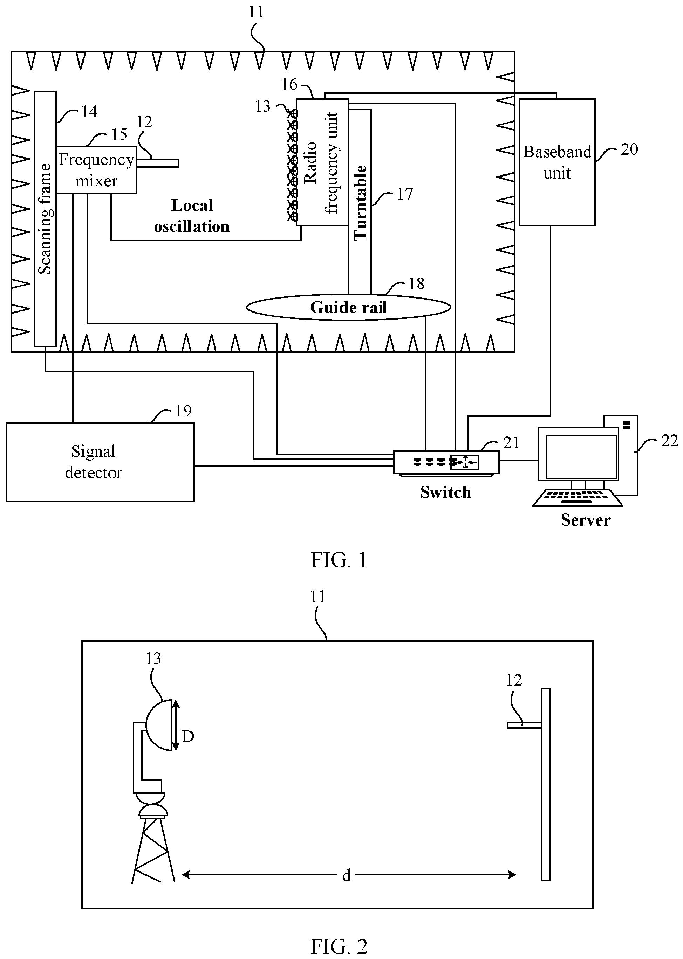

FIG. 1 is a schematic diagram of a specific embodiment of a MIMO test system. The MIMO test system includes an electromagnetic anechoic chamber 11, a scanning frame 14 disposed in the electromagnetic anechoic chamber 11, a frequency mixer 15 and a receive antenna 12 that are fixed on the scanning frame, a turntable 17, a radio frequency unit 16 and a transmit antenna array 13 that are fixed on the turntable, and a guide rail 18 for sliding the turntable 17. In addition, the MIMO test system further includes a signal detector 19 connected to the frequency mixer 15 and the radio frequency unit 16, a baseband unit 20 connected to the radio frequency unit 16, a switch 21, and a server 22. The scanning frame 14, the frequency mixer 15, the radio frequency unit 16, the signal detector 19, the baseband unit 20, and the server 22 are all connected to the switch 21.

The electromagnetic anechoic chamber 11 is an enclosed shielding chamber, and is configured to screen an electromagnetic signal outside the electromagnetic anechoic chamber 11. The baseband unit 20 may be disposed in the electromagnetic anechoic chamber 11, or may be disposed outside the electromagnetic anechoic chamber 11.

A local-frequency signal of the radio frequency unit 16 keeps consistent with that of the frequency mixer 15. In the frequency mixer 15, the local-frequency signal and a high-frequency signal are mixed to generate an intermediate frequency.

A signal is received by using the receive antenna 12. The frequency mixer 15 performs frequency mixing on the received signal, and then transmits the signal to the signal detector 19 (for example, a signal source, a spectrum analyzer, or a power meter). The signal detector 19 and/or the server 22 calculate the received signal, to obtain a value of each signal metric. The signal metric may be at least one of effective isotropic sensitivity (Effective Isotropic Sensitive, EIS), an error vector magnitude (Error Vector Magnitude, EVM), an adjacent channel leakage ratio (Adjacent Channel Leakage Ratio, ACLR), equivalent isotropic radiated power (Equivalent Isotropic Radiated Power, EIRP), and a bit error rate (Bit Error Rate, BER).

In the prior art, a MIMO test system includes a transmit device configured to transmit a MIMO signal and a test device configured to receive a MIMO signal. An antenna array of a MIMO device includes N mutually independent antenna units, and each antenna unit may be an antenna or an antenna bay. When the antenna unit is an antenna bay, phases of signals transmitted by all antennas in the antenna bay are always consistent. A phase is a physical quantity that reflects a status of an antenna signal at any moment. At a moment t, the phase of the antenna signal is a location of the moment t in a signal period.

The following describes, based on the electromagnetic anechoic chamber 11 shown in FIG. 1, a restrictive condition of the electromagnetic anechoic chamber 11. Referring to FIG. 2, in the electromagnetic anechoic chamber 11, an array aperture of the transmit antenna array 13 is denoted as D, a distance between the transmit antenna array 13 and the receive antenna 12 is denoted as d, and a wavelength of a test signal is denoted as $\lambda$. In this case, the following condition needs to be met during the test: $d \geq 2D^2 / \lambda$. If this condition is met, signals transmitted by different transmit antennas can be in-phase superposed at a receive antenna, on signals transmitted by different transmit antennas, and the receive antenna may receive a compound signal that can meet a measurement requirement. If this condition is not met, a phase difference between different antennas is large at the receive antenna. In this case, an obtained signal metric value differs greatly from that measured in a far-field test environment, that is, an error is very large, and the test requirement cannot be met.

For example, a wavelength of 5 GHz is approximately 6 cm. If an array aperture of the antenna array is 60 cm, the distance d between the transmit antenna array and the receive antenna array needs to be greater than 12 m. If the array aperture of the antenna array is 1 m, the distance d between the transmit antenna array and the receive antenna array needs to be greater than 33.34 m. Therefore, it can be seen that the space of the anechoic chamber in the far-field test system is limited by the distance between the transmit antenna array and the receive antenna array. On the one hand, it is costly to build a large anechoic chamber. On the other hand, as antennas in an antenna array increase, an aperture of the antenna array also becomes larger, and the space of the anechoic chamber needs to be larger. A previous anechoic chamber cannot meet a subsequent antenna measurement condition.

To resolve the foregoing problem, this application provides a signal test method, so that signal measurement can be implemented in a condition of $d < 2D^2 / \lambda$, that is, within a distance threshold. The following describes in detail the signal test method provided in this application.

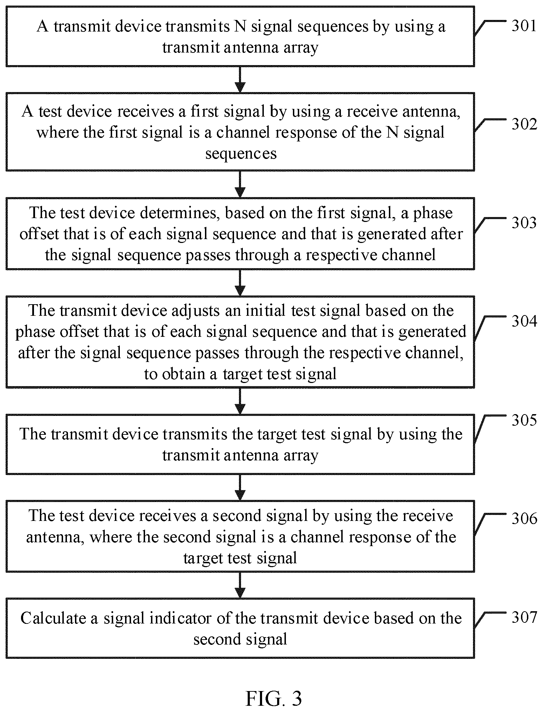

Referring to FIG. 3, in an embodiment, a signal test method provided in this application includes the following steps.

Step 301: A transmit device transmits N signal sequences by using a transmit antenna array.

In this embodiment, the transmit antenna array of the transmit device includes N transmit antenna units, where N is a positive integer greater than 1. The transmit antenna array may include N antennas, or may include N antenna bays. When the transmit antenna array includes N antennas, a phase of a signal to be transmitted by each antenna is independently adjustable. When the transmit antenna array includes N antenna bays, each antenna bay includes a plurality of antennas, and phases of signals to be transmitted by all antennas in each antenna bay keep consistent.

The N signal sequences are orthogonal to each other. Signal sequences that are orthogonal to each other are also referred to as a code group. Each code group includes m code words, and the code words are used to represent a binary character string. The N signal sequences may be N signal sequences selected from an orthogonal sequence. The orthogonal sequence may be an m sequence, a Golden sequence, a Walsh sequence, a LAS sequence, a Golay sequence, a Kasami sequence, or another orthogonal sequence. It may be understood that a quantity of signal sequences is the same as a quantity of transmit antenna units.

Step 302: A test device receives a first signal by using a receive antenna, where the first signal is a channel response to the N signal sequences.

Because the N signal sequences are orthogonal to each other, that is, the N signal sequences are not correlated, a channel from the N transmit antenna units to the receive antenna may be considered as N independent channels.

A transmitted $k^{th}$ signal sequence is denoted as $C_k$, and a received $k^{th}$ signal sequence is denoted as $C'_k$. In an electromagnetic anechoic chamber, the transmitted signal sequence $C_k$ and the received signal sequence $C'_k$ meet the following formula:

$$\mathbf{C'_k} = \alpha_k \cdot \mathbf{C_k} \cdot e^{j\Delta\varphi_k},$$

where

$\alpha_k$ is an attenuation amplitude that is of the $k^{th}$ signal sequence and that is generated after the $k^{th}$ signal sequence passes through a channel, and $\Delta\varphi_k$ is a phase offset that is of the $k^{th}$ signal sequence and that is generated after the $k^{th}$ signal sequence passes through a channel.

For example, the N signal sequences are $\{C_1, C_2, ..., C_n\}$, and the first signal $C_r$ and the N signal sequences meet the following formula:

$$\mathbf{C_r} = \alpha_1 \mathbf{C_1} e^{j\Delta\varphi_1} + \alpha_2 \mathbf{C_2} e^{j\Delta\varphi_2} + ... + \alpha_n \mathbf{C_n} e^{j\Delta\varphi_n},$$

where

$\alpha_n$ is an attenuation amplitude that is of the $n^{th}$ signal sequence and that is generated after the $n^{th}$ signal sequence passes through a channel, and $\Delta\varphi_n$ is a phase offset that is of the $n^{th}$ signal sequence and that is generated after the $n^{th}$ signal sequence passes through a channel, and so on.

Step 303: The test device determines, based on the first signal, a phase offset that is of each signal sequence and that is generated after the signal sequence passes through a channel.

Specifically, a correlation operation is performed on the first signal $C_r$ and the N signal sequences, to obtain the phase offset that is of each signal sequence and that is generated after the signal sequence passes through the channel, that is, $\Delta\varphi_1\Delta\varphi_2...,\Delta\varphi_n$.

$C_k$ includes m codewords, denoted as $C_{k1}, C_{k2},...,C_{km}$. $\mathbf{C^*_k}$ is a conjugate of $C_k$. $C_i$ is a signal sequence different from $C_k$ in the N signal sequences, and codewords included in $C_i$ are denoted as $C_{i1}, C_{i2},...,C_{im}$.

$C_k$, $\mathbf{C^*_k}$, $C_i$ meet the following formula:

$$\mathbf{C_k} \cdot \mathbf{C^*_k} = c_{k1} \times c^*_{k1} + c_{k2} \times c^*_{k2} + ... + c_{km} \times c^*_{km} = m;$$

and

$$\mathbf{C_i} \cdot \mathbf{C^*_k} = c_{i1} \times c^*_{k1} + c_{i2} \times c^*_{k2} + ... + c_{im} \times c^*_{km} = 0.$$

$C_r$ and $\mathbf{C^*_k}$ meet the following formula:

$$\mathbf{C_r} \cdot \mathbf{C_k}^* = \mathbf{C_1'} \cdot \mathbf{C_k}^* + \mathbf{C_2'} \cdot \mathbf{C_k}^* + ... + \mathbf{C_k'} \cdot \mathbf{C_k}^* + ... + \mathbf{C_n'} \cdot \mathbf{C_k}^*$$
$$= 0 + 0 + ... + \alpha_k \cdot m \cdot e^{j\Delta\varphi_k} + ... + 0$$
$$= \alpha_k \cdot m \cdot e^{j\Delta\varphi_k}$$

Because m is a known value, the attenuation amplitude and the phase offset that are of each signal sequence and that are generated after the signal sequence passes through the channel may be obtained by decoupling signals of the antennas.

Step 304: The transmit device adjusts an initial test signal based on the phase offset that is of each signal sequence and that is generated after the signal sequence passes through the respective channel, to obtain a target test signal.

Specifically, the initial test signal is a signal sequence. The signal sequence herein may be a service signal sequence, or may be another type of signal sequence for testing. This is not limited in this application. The target test signal includes a plurality of signal sequences obtained by separately performing phase adjustment on the initial test signal based on the phase offset that is of each signal sequence and that is generated after the signal sequence passes through the respective channel. One signal sequence in the target test signal is obtained by performing phase adjustment on the initial test signal based on one phase offset. The N signal sequences in the target test signal are obtained by performing phase adjustment on the initial test signal based on the N phase offsets.

In an optional embodiment, the N phase offsets are respectively $-\Delta\varphi_1, -\Delta\varphi_2, ..., -\Delta\varphi_n$, and $-\Delta\varphi_k$ is added to a phase of the initial test signal to calculate a phase of the $k^{th}$ signal sequence in the target test signal, k is any positive integer that belongs to [1, N]. In this way, when signal sequences of the target test signal are transmitted from the transmit antenna to the receive antenna, phases of the signal sequences are consistent at the receive antenna.

In another optional embodiment, a phase offset $\Delta\varphi_k$ is selected as a reference value, and a difference between each phase offset and the reference value is calculated. The foregoing calculation result is added to the phase of the initial test signal to calculate a phase of each signal sequence in the target test signal.

For example, $\Delta\varphi_{1k} = \Delta\varphi_1 - \Delta\varphi_k$, where $\Delta\varphi_{1k}$ is a difference between a phase offset of a first signal sequence in the target test signal and the reference value. A phase of a first signal sequence in the target test signal is calculated by adding $\Delta\varphi_{1k}$ to the phase of the initial test signal. By analogy, $\Delta\varphi_{2k}, ..., \Delta\varphi_{nk}$, are calculated, to obtain a phase of each signal sequence in the target test signal. That is, when the phase offset of the first signal sequence at the receive antenna is earlier than the reference value by $\Delta t$, the phase offset of the first signal sequence at the transmit antenna is delayed by $\Delta t$. When the phase offset of the first signal sequence at the receive antenna lags behind the reference value by $\Delta t$, the phase offset of the first signal sequence at the transmit antenna is advanced by $\Delta t$. In this way, when signal sequences in the target test signal are transmitted from the transmit antenna to the receive antenna, phases of the signal sequences can be consistent at the receive antenna.

In this application, an antenna located in the center of the transmit antenna array may be selected as a target antenna, and a phase offset of a signal sequence to be transmitted by the target antenna is used as the reference value. Alternatively, an antenna located in the middle area of the transmit antenna array is used as a target antenna, and a phase offset of a signal sequence to be transmitted by the target antenna is used as a reference value. It may be understood that a specific antenna in the transmit antenna array that is selected as the target antenna is not limited in this application.

In this way, phase adjustment is performed on the initial test signal based on the phase offset that is of each signal sequence and that is generated after the signal sequence passes through the respective channel, so that the test signal after phase adjustment (namely, the target test signal) can be in-phase superposed at the receive antenna.

Optionally, the phase offset, the initial test signal, and the signal sequence of the target test signal meet the following formula:

$$\mathbf{S_{tk}} = \mathbf{S_t} e^{-j\Delta\varphi_k},$$

where
$S_{tk}$ is the $k^{th}$ signal sequence in the target test signal, $S_t$ is the initial test signal, and k is not greater than N.

Step 305: The transmit device transmits the target test signal by using the transmit antenna array.

Step 306: The test device receives a second signal by using the receive antenna, where the second signal is a channel response to the target test signal.

In an optional embodiment, the target test signal, the second signal, and the phase offset meet the following formula:

$$\mathbf{S_r} = \alpha_1 \mathbf{S_{t1}} e^{j\Delta\varphi_1} + \alpha_2 \mathbf{S_{t2}} e^{j\Delta\varphi_2} + \ldots + \alpha_n \mathbf{S_{tn}} e^{j\Delta\varphi_n}$$
$$= \alpha_1 \mathbf{S_t} + \alpha_2 \mathbf{S_t} + \ldots + \alpha_n \mathbf{S_t}$$
$$= \sum_{i=1}^{n} \alpha_i \mathbf{S_t}$$

$, \backslash$

where

i is not greater than n.

Step 307: The test device calculates a signal metric of the transmit device based on the second signal.

It should be noted that $\alpha$ is an attenuation amplitude after a channel is passed through, and $\Delta\varphi$ is a phase offset after a channel is passed through. Therefore, $\alpha_n$ is not only an attenuation amplitude that is of an $n^{th}$ signal sequence and that is generated after the $n^{th}$ signal sequence passes through a channel, but also an attenuation amplitude that is of an $n^{th}$ signal sequence of the target test signal and that is generated after the $n^{th}$ signal sequence passes through a channel. Similarly, $\Delta\varphi_n$ is not only a phase offset that is of the $n^{th}$ signal sequence and that is generated after the $n^{th}$ signal sequence passes through a channel, but also a phase offset that is of the $n^{th}$ signal sequence of the target test signal and that is generated after the $n^{th}$ signal sequence passes through a channel.

In a short-distance environment, phase offsets of different antennas at the receive antenna can be calculated according to the formulas provided in this application, and then corresponding phase adjustment is performed based on the phase offsets, so that after passing through transmission paths of different lengths, antenna signals can be in-phase superposed at the receive antenna. This resolves a prior-art problem that a large error is caused because a phase difference at the receive antenna is excessively large, and a test requirement cannot be met. Because all signal sequences of the target test signal are transmitted to form the second signal at the receive antenna, an accurate and reliable signal metric may be calculated based on the second signal.

In the prior art, when transmitting N antenna signals by using N antennas, to avoid signal interference, the transmit device transmits one antenna signal each time by using a single antenna. In this way, although signal interference is avoided, it takes a relatively long time. In this application, N transmit antennas may be used to simultaneously transmit N antenna signals, to improve test efficiency.

In an optional embodiment, step 301 specifically includes: simultaneously transmitting, by the transmit device, the N signal sequences by using the transmit antenna array.

In this embodiment, the N signal sequences are orthogonal to each other. Because interference between orthogonal signals is very small, after receiving the compound signal obtained by in-phase superposing the N signal sequences, the test device may still decouple the compound signal to obtain a signal parameter of each antenna signal. Therefore, a time used for transmitting a signal sequence is reduced, and test efficiency can be improved.

In another optional embodiment, step 305 specifically includes: simultaneously transmitting, by the transmit device by using the transmit antenna array, the N signal sequences included in the target test signal.

In this embodiment, the N signal sequences included in the target test signal are orthogonal to each other. Because interference between orthogonal signals is very small, after receiving the compound signal obtained by in-phase superposing the N signal sequences, the test device may still decouple the compound signal to obtain a signal parameter of each antenna signal. Therefore, a time used for transmitting a signal sequence is reduced, and test efficiency can be improved.

It should be noted that the transmit device may simultaneously transmit the N signal sequences, and transmit, at different time points, the N signal sequences included in the target test signal. Alternatively, the transmit device may transmit the N signal sequences at different time points, and simultaneously transmit the N signal sequences included in the target test signal. Alternatively, the transmit device may simultaneously transmit the N signal sequences, and simultaneously transmit the N signal sequences included in the target test signal.

It should be noted that in addition to phase adjustment on a test signal, signal strength of the test signal may also be adjusted. Details are described below.

In another optional embodiment, the method for testing a MIMO signal further includes: determining, based on the first signal, an attenuation amplitude that is of each signal sequence and that is generated after the signal sequence passes through a channel; and

step 304 includes: adjusting the initial test signal based on the phase offset and the attenuation amplitude that are of each signal sequence and that are generated after the signal sequence passes through the channel, to obtain the target test signal.

In this embodiment, the phase offset, the initial test signal, and the signal sequence of the target test signal meet the following formula:

$$\mathbf{S_{tk}} = \frac{1}{\alpha_k} \mathbf{S_t} e^{-j\Delta\varphi_k}.$$

The target test signal, the second signal, and the phase offset meet the following formula:

$$\begin{aligned}
\mathbf{S_r} &= \alpha_1 \mathbf{S_{t1}} e^{j\Delta\varphi_1} + \alpha_2 \mathbf{S_{t2}} e^{j\Delta\varphi_2} + \ldots + \alpha_n \mathbf{S_{tn}} e^{j\Delta\varphi_n} \\
&= \mathbf{S_t} + \mathbf{S_t} + \ldots + \mathbf{S_t} \\
&= n\mathbf{S_t}
\end{aligned},$$

where
$S_{tk}$ is the $k^{th}$ signal sequence in the target test signal, $S_t$ is the initial test signal, $\alpha_k$ is an attenuation amplitude that is of the $k^{th}$ signal sequence and that is generated after the $k^{th}$ signal sequence passes through a channel, and k is not greater than N.

In this embodiment, the N signal sequences of the target test signal are in-phase superposed at the receive antenna, so that the receive antenna can receive a signal that meets a test requirement. In this way, not only phase adjustment can be performed on the test signal, but also an attenuation amplitude of the test signal can be adjusted, thereby expanding a test application scope.

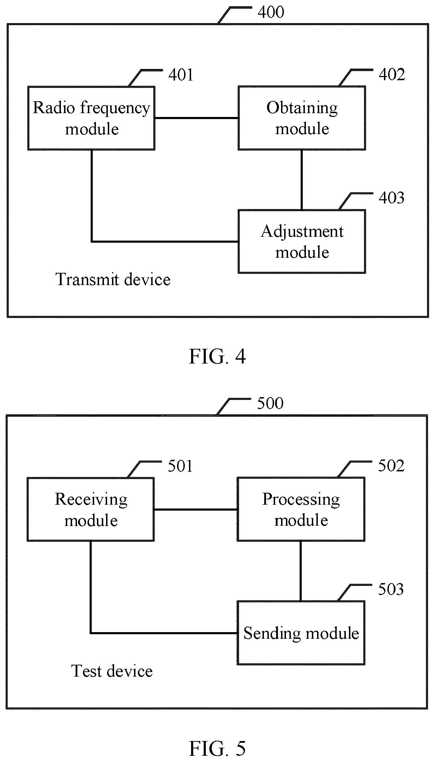

Referring to FIG. 4, in an embodiment, a transmit device 400 provided in this application includes:

a radio frequency module 401, configured to transmit N signal sequences by using a transmit antenna array, where the N signal sequences are orthogonal to each other, N is a positive integer greater than 1, the radio frequency module 401 may be specifically a radio frequency unit (Radio Remote Unit), for example, a radio frequency unit 16, and may include an intermediate frequency module, a transceiver module, a power amplifier, and a filter module, the digital intermediate frequency module is configured for modulation and demodulation of optical transmission, digital up- and down-conversion, A/D conversion, and the like, the transceiver module completes conversion from an intermediate frequency signal to a radio frequency signal, and then the power amplifier and the filter module transmit the radio frequency signal by using an antenna port;

an obtaining module 402, configured to obtain, from a test device, a phase offset that is of each signal sequence and that is generated after the signal sequence passes through a channel, where the test device is configured to test a signal metric of the transmit device, and the obtaining module 402 may specifically include an I/O interface and a corresponding data storage component; and

an adjustment module 403, further configured to adjust an initial test signal based on the phase offset that is of each signal sequence and that is generated after the signal sequence passes through the channel, to obtain a target test signal in-phase superposed at the test device, where the target test signal includes a plurality of signal sequences obtained by separately performing phase adjustment on the initial test signal based on the phase offset that is of each signal sequence and that is generated after the signal sequence passes through the respective channel, during specific implementation, a digital signal may be adjusted by using a device such as a device processor, a digital signal processor, a field programmable gate array, or an external device, and an analog signal may be adjusted by using an external phase adjustment device and an attenuator.

The radio frequency module 401 is further configured to transmit the target test signal by using the transmit antenna array.

In an optional embodiment, the phase offset, the initial test signal, and the signal sequence of the target test signal meet the following formula:

$$\mathbf{S_{tk}} = \mathbf{S_t} e^{-j\Delta\varphi_k},$$

where
$S_{tk}$ is a $k^{th}$ signal sequence in the target test signal, $\mathbf{S_t}$ is the initial test signal, $\Delta\varphi_k$ is a phase offset that is of the $k^{th}$ signal sequence and that is generated after the $k^{th}$ signal sequence passes through a channel, and k is not greater than N.

In another optional embodiment,

the obtaining module 402 is further configured to obtain, from the test device, an attenuation amplitude that is of each signal sequence and that is generated after the signal sequence passes through a channel; and

the radio frequency module 401 is further configured to adjust the initial test signal based on the phase offset and the attenuation amplitude that are of each signal sequence and that are generated after the signal sequence passes through the channel, to obtain the target test signal.

In another optional embodiment, the phase offset, the attenuation amplitude, the initial test signal, and the signal sequence of the target test signal meet the following formula:

$$\mathbf{S_{tk}} = \frac{1}{\alpha_k}\mathbf{S_t}e^{-j\Delta\varphi_k},$$

where
$S_{tk}$ is a $k^{th}$ signal sequence in the target test signal, $\mathbf{S_t}$ is the initial test signal, $\alpha_k$ is an attenuation amplitude that is of the $k^{th}$ signal sequence and that is generated after the $k^{th}$ signal sequence passes through a channel, $\Delta\varphi_k$ is a phase offset that is of the $k^{th}$ signal sequence and that is generated after the $k^{th}$ signal sequence passes through a channel, and k is not greater than N.

In another optional embodiment, the radio frequency module 401 is specifically configured to simultaneously transmit the N signal sequences by using the transmit antenna array, where the N signal sequences are orthogonal to each other.

In another optional embodiment, the radio frequency module 401 is specifically configured to simultaneously transmit, by using the transmit antenna array, N signal sequences included in the target test signal.

Referring to FIG. 5, in an embodiment, a test device 500 provided in this application includes:

a receiving module 501, configured to receive a first signal by using a receive antenna, where the first signal is a channel response to N signal sequences sent by a transmit device by using a transmit antenna array, the N signal sequences are orthogonal to each other, and the receiving module 501 may be specifically a component such as a radio frequency receiving channel or an analog-to-digital converter;
a processing module 502, configured to determine, based on the first signal, a phase offset that is of each signal sequence in the N signal sequences and that is generated after the signal sequence passes through a channel; and the processing module 502 may be specifically a central processing unit, a field programmable gate array, a digital signal processor, or another dedicated circuit having a signal processing function; and
a sending module 503, configured to send, to the transmit device, the phase offset that is of each signal sequence and that is generated after the signal sequence passes through the channel, where in an actual application, the test device may send the offset to a to-be-tested MIMO device in a wired connection manner such as a serial port or an Ethernet port or in a wireless transmission manner.

The receiving module 501 is further configured to receive a second signal by using the receive antenna, where the second signal is a channel response to the target test signal, and the target test signal is obtained by adjusting, by the transmit device, the initial test signal based on the phase offset that is of each signal sequence and that is generated after the signal sequence passes through the channel; and
the processing module 502 is further configured to calculate a signal metric of the transmit device based on the second signal.

In an optional embodiment,

the processing module 502 is further configured to determine, based on the first signal, an attenuation amplitude that is of each signal sequence and that is generated after the signal sequence passes through a channel; and
the sending module 503 is further configured to send, to the transmit device, the attenuation amplitude that is of each signal sequence and that is generated after the signal sequence passes through the respective channel.

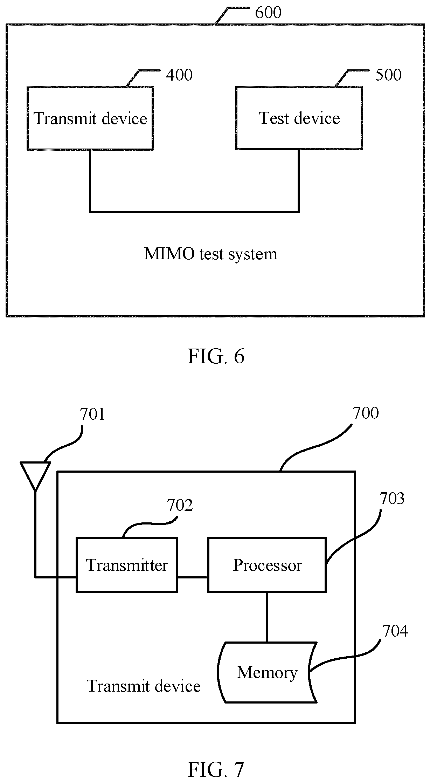

Referring to FIG. 6, in an embodiment, a MIMO test system 600 provided in this application includes a transmit device 400 and a test device 500.

The transmit device 400 is the transmit device in the embodiment shown in FIG. 4 or the foregoing optional embodiment. The test device 500 is the test device in the embodiment shown in FIG. 5 or the foregoing optional embodiment.

The following describes the transmit device and the test device in this application from a perspective of a hardware device.

Referring to FIG. 7, in another embodiment, a transmit device 700 provided in this application includes: a transmit antenna array 701, a transmitter 702, a processor 703, and a memory 704.

The transmit antenna array 701 is connected to the transmitter 702. Both the transmitter 702 and the memory 704 are connected to the processor 703, for example, may be connected to the processor 703 by using a bus. Certainly, the transmit device 700 may further include general components such as a receiver, a baseband processing component, an intermediate radio frequency processing component, an input/output apparatus, and a communications interface. This is not limited herein in this embodiment. The receiver and the transmitter may be integrated to constitute a transceiver.

The processor 703 may be a general-purpose processor, including a central processing unit (Central Processing Unit, CPU for short), a network processor (Network Processor, NP for short), or the like. Alternatively, the processor may be a digital signal processor (Digital Signal Processor, DSP for short), an application specific integrated circuit (Application Specific Integrated Circuit, ASIC for short), a field-programmable gate array (Field-Programmable Gate Array, FPGA for short), another programmable logic component, or the like.

The memory 704 is configured to store a program. Specifically, the program may include program code, and the program code includes a computer operation instruction. The memory 802 may include a random access memory (Random Access Memory, RAM for short), or may further include a non-volatile memory (Non-Volatile Memory, NVM for short), for example, at least one disk storage.

During an implementation,

the transmitter 702 is configured to transmit N signal sequences by using the transmit antenna array 701, where the N signal sequences are orthogonal to each other, and N is a positive integer greater than 1;
the processor 703 is configured to obtain, from a test device, a phase offset that is of each signal sequence and that is generated after the signal sequence passes through a channel; and
the processor 703 is further configured to adjust an initial test signal based on a phase offset that is of each signal sequence and that is generated after the signal sequence passes through a channel, to obtain a target test signal in-phase superposed at the test device, where the target test signal includes a plurality of signal sequences obtained by separately performing phase adjustment on the initial test signal based on the phase offset that is of each signal sequence and that is generated after the signal sequence passes through the respective channel.

The transmitter 702 is further configured to transmit the target test signal by using the transmit antenna array 701.

The processor 703 executes program code stored in the memory 704, to implement functions of the transmit device in the embodiment shown in FIG. 3 or the foregoing optional embodiment.

In another implementation, the transmitter 702 may implement a function of the radio frequency module 401 in the embodiment shown in FIG. 4. The processor 703 may implement functions of the obtaining module 402 and the adjustment module 403 in the embodiment shown in FIG. 4.

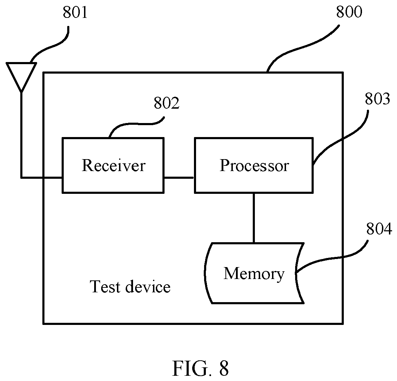

Referring to FIG. 8, in another embodiment, a test device 800 provided in this application includes: a receive antenna 801, a receiver 802, a processor 803, and a memory 804.

The receive antenna 801 is connected to the receiver 802. Both the receiver 802 and the memory 804 are connected to the processor 803, for example, may be connected to the processor 803 by using a bus. Certainly, the test device 800 may further include general components such as a transmitter, a baseband processing component, an intermediate radio frequency processing component, an input/output apparatus, and a communications interface. This is not limited herein in this embodiment. The receiver and the transmitter may be integrated to constitute a transceiver.

The processor 803 may be a general-purpose processor, including a CPU, an NP, or the like. Alternatively, the processor may be a DSP, an ASIC, an FPGA, another programmable logic device, or the like.

The memory 804 is configured to store a program. Specifically, the program may include program code, and the program code includes a computer operation instruction. The memory 804 may include a RAM, or may further include an NVM, for example, at least one disk storage. The processor 803 executes program code stored in the memory 804, to implement functions of the test device in the embodiment shown in FIG. 3 or the foregoing optional embodiment.

During an implementation, the receiver 802 is configured to receive a first signal by using the receive antenna 801, where the first signal is a channel response to N signal sequences sent by a transmit device by using a transmit antenna array, the N signal sequences are orthogonal to each other, and N is a positive integer greater than 1;

the processor 803 is configured to determine, based on the first signal, a phase offset that is of each signal sequence in the N signal sequences and that is generated after the signal sequence passes through a respective channel;
the processor 803 is further configured to send, to the transmit device, the phase offset that is of each signal sequence and that is generated after the signal sequence passes through a respective channel;
the receiver 802 is further configured to receive a second signal by using the receive antenna 801, where the second signal is a channel response to the target test signal, and the target test signal is obtained by adjusting, by the transmit device, the initial test signal based on the phase offset that is of each signal sequence and that is generated after the signal sequence passes through the channel; and
the processor 803 is further configured to calculate a signal metric of the transmit device based on the second signal.

In another implementation, the receiver 802 may implement a function of the receiving module in the embodiment shown in FIG. 5 or the foregoing optional embodiment. The processor 803 may implement a function of the processing module 502 in the embodiment shown in FIG. 5. The communications interface may implement a function of the sending module 503 under control of the processor 803.

This application further provides a computer storage medium, including an instruction. When the instruction is executed on a computer, the computer is enabled to perform the method in the foregoing embodiment.

All or some of the foregoing embodiments may be implemented by using software, hardware, firmware, or any combination thereof. When software is used to implement the embodiments, the embodiments may be implemented completely or partially in a form of a computer program product.

The computer program product includes one or more computer instructions. When the computer program instructions are loaded and executed on the computer, the procedure or functions according to the embodiments of the present invention are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (Solid State Disk, SSD)), or the like.

## Claims

1. A test method, comprising:

   transmitting (301), by a transmit device, N signal sequences by using a transmit antenna array, wherein the N signal sequences are orthogonal to each other, and N is a positive integer greater than 1;
   obtaining (303), by the transmit device from a test device, a phase offset that is of each signal sequence in the N signal sequences and that is generated after the signal sequence passes through a respective channel;
   adjusting (304), by the transmit device, an initial test signal based on the phase offset that is of each signal sequence and that is generated after the signal sequence passes through the respective channel, to obtain a target test signal in-phase superposed at the test device, wherein the target test signal comprises a plurality of signal sequences obtained by separately performing phase adjustment on the initial test signal based on the phase offset that is of each signal sequence and that is generated after the signal sequence passes through the respective channel; and
   transmitting (305), by the transmit device, the target test signal by using the transmit antenna array,
   wherein an array aperture of the transmit antenna array denoted as D, a distance between the transmit antenna array and a receive antenna denoted as d and a wavelength of the target test signal denoted as $\lambda$ satisfy a condition of: $d < 2D^2 / \lambda$.

2. The method according to claim 1, wherein the phase offset, the initial test signal, and a signal sequence of the target test signal meet a following formula:

$$\mathbf{S_{tk}} = \mathbf{S_t} e^{-j\Delta\varphi_k},$$

   wherein
   $S_{tk}$ is a $k^{th}$ signal sequence in the target test signal, $\mathbf{S_t}$ is the initial test signal, $\Delta\varphi_k$ is a phase offset that is of the $k^{th}$ signal sequence and that is generated after the $k^{th}$ signal sequence passes through a channel, and k is not greater than N.

3. The method according to claim 1, wherein

   the method further comprises: obtaining, by the transmit device from the test device, an attenuation amplitude that is of each signal sequence and that is generated after the signal sequence passes through a respective channel; and

the adjusting (304), by the transmit device, an initial test signal based on the phase offset that is of each signal sequence and that is generated after the signal sequence passes through the respective channel, to obtain a target test signal includes: adjusting, by the transmit device based on the phase offset and the attenuation amplitude that are of each signal sequence and that are generated after the signal sequence passes through the respective channel, the initial test signal to obtain the target test signal.

4. The method according to claim 3, wherein the phase offset, the attenuation amplitude, the initial test signal, and a signal sequence of the target test signal meet a following formula:

$$\mathbf{S_{tk}} = \frac{1}{\alpha_k}\mathbf{S_t}e^{-j\Delta\varphi_k},$$

wherein
$S_{tk}$ is a $k^{th}$ signal sequence in the target test signal, $\mathbf{S_t}$ is the initial test signal, $\alpha_k$ is the attenuation amplitude that is of the $k^{th}$ signal sequence and that is generated after the $k^{th}$ signal sequence passes through a channel, $\Delta\varphi_k$ is a phase offset that is of the $k^{th}$ signal sequence and that is generated after the $k^{th}$ signal sequence passes through the channel, and k is not greater than N.

5. The method according to any one of claims 1 to 4, wherein the N signal sequences are N signal sequences selected from an orthogonal sequence, and the orthogonal sequence is an m sequence, a Golden sequence, a Walsh sequence, a LAS sequence, a Golay sequence, or a Kasami sequence.

6. The method according to any one of claims 1 to 4, wherein the transmitting (301), by a transmit device, N signal sequences by using a transmit antenna array comprises:
simultaneously transmitting, by the transmit device, the N signal sequences by using the transmit antenna array.

7. The method according to any one of claims 1 to 4, wherein the transmitting (305), by the transmit device, the target test signal by using the transmit antenna array comprises:
simultaneously transmitting, by the transmit device, the target test signal by using the transmit antenna array, wherein the target test signal comprises N signal sequences.

8. A test method, comprising:

receiving (302), by a test device, a first signal by using a receive antenna, wherein the first signal is a channel response of N signal sequences sent by a transmit device by using a transmit antenna array, the N signal sequences are orthogonal to each other, and N is an integer greater than 1;
determining, by the test device based on the first signal, a phase offset that is of each signal sequence in the N signal sequences and that is generated after the signal sequence passes through a respective channel;
sending, by the test device to the transmit device, the phase offset that is of each signal sequence and that is generated after the signal sequence passes through the respective channel;
receiving (306), by the test device, a second signal by using the receive antenna, wherein the second signal is a channel response of a target test signal, the target test signal comprises a plurality of signal sequences obtained by adjusting, by the transmit device, an initial test signal based on the phase offset that is of each signal sequence and that is generated after the signal sequence passes through the respective channel, and the target test signal is in-phase superposed at the test device; and
calculating (307), by the test device, a signal indicator of the transmit device based on the second signal, wherein an array aperture of the transmit antenna array denoted as D, a distance between the transmit antenna array and the receive antenna denoted as d and a wavelength of the target test signal denoted as $\lambda$ satisfy a condition of: $d < 2D^2 / \lambda$.

9. The method according to claim 8, wherein the method further comprises:

determining, by the test device based on the first signal, an attenuation amplitude that is of each signal sequence and that is generated after the signal sequence passes through a respective channel; and
sending, by the test device to the transmit device, the attenuation amplitude that is of each signal sequence and that is generated after the signal sequence passes through the respective channel.

10. A transmit device (400), comprising:

a radio frequency module (401), configured to transmit N signal sequences by using a transmit antenna array, wherein the N signal sequences are orthogonal to each other, the transmit antenna array comprises N transmit antenna units, and N is an integer greater than 1;
an obtaining module (402), configured to obtain, from a test device, a phase offset that is of each signal sequence in the N signal sequences and that is generated after the signal sequence passes through a respective channel; and
an adjustment module (403), configured to adjust an initial test signal based on the phase offset that is of each signal sequence and that is generated after the signal sequence passes through the respective channel, to obtain a target test signal in-phase superposed at the test device, wherein the target test signal comprises a plurality of signal sequences obtained by separately performing phase adjustment on the initial test signal based on the phase offset that is of each signal sequence and that is generated after the signal sequence passes through the respective channel; and
the radio frequency module (401) is further configured to transmit the target test signal by using the transmit antenna array,
wherein an array aperture of the transmit antenna array denoted as D, a distance between the transmit antenna array and a receive antenna denoted as d and a wavelength of the target test signal denoted as $\lambda$ satisfy a condition of: $d < 2D^2 / \lambda$.

11. The transmit device (400) according to claim 10, wherein the phase offset, the initial test signal, and a signal sequence of the target test signal meet a following formula:

$$\mathbf{S_{tk}} = \mathbf{S_t} e^{-j\Delta\varphi_k} ,$$

wherein
$S_{tk}$ is a $k^{th}$ signal sequence in the target test signal, $\mathbf{S_t}$ is the initial test signal, $\Delta\varphi_k$ is a phase offset that is of the $k^{th}$ signal sequence and that is generated after the $k^{th}$ signal sequence passes through a channel, and k is not greater than N.

12. The transmit device (400) according to claim 10, wherein

the obtaining module (402) is further configured to obtain, from the test device, an attenuation amplitude that is of each signal sequence and that is generated after the signal sequence passes through a respective channel; and
the radio frequency module (401) is further configured to adjust the initial test signal based on the phase offset and the attenuation amplitude that are of each signal sequence and that are generated after the signal sequence passes through the respective channel, to obtain the target test signal.

13. The transmit device (400) according to claim 12, wherein the phase offset, the attenuation amplitude, the initial test signal, and a signal sequence of the target test signal meet a following formula:

$$\mathbf{S_{tk}} = \frac{1}{\alpha_k} \mathbf{S_t} e^{-j\Delta\varphi_k} ,$$

wherein
$S_{tk}$ is a $k^{th}$ signal sequence in the target test signal, $\mathbf{S_t}$ is the initial test signal, $\alpha_k$ is the attenuation amplitude that is of the $k^{th}$ signal sequence and that is generated after the $k^{th}$ signal sequence passes through a channel, $\Delta\varphi_k$ is a phase offset that is of the $k^{th}$ signal sequence and that is generated after the $k^{th}$ signal sequence passes through the channel, and k is not greater than N.

14. The transmit device (400) according to any one of claims 10 to 13, wherein
the radio frequency module (401) is specifically configured to simultaneously transmit the N signal sequences by using the transmit antenna array, and the N signal sequences are orthogonal to each other.

15. The transmit device (400) according to any one of claims 10 to 13, wherein

the radio frequency module (401) is specifically configured to simultaneously transmit the target test signal by using the transmit antenna array, and the target test signal comprises N signal sequences.

**Patentansprüche**

1. Testverfahren, das Folgendes umfasst:

   Übertragen (301), durch eine Sendevorrichtung, von N Signalsequenzen durch Verwenden eines Sendeantennenarrays, wobei die N Signalsequenzen orthogonal zueinander sind und N eine positive ganze Zahl größer als 1 ist,
   Erhalten (303), durch die Sendevorrichtung von einer Testvorrichtung, eines Phasenversatzes, der von jeder Signalsequenz in den N Signalsequenzen stammt und der erzeugt wird, nachdem die Signalsequenz einen jeweiligen Kanal durchlaufen hat;
   Anpassen (304), durch die Sendevorrichtung, eines Anfangstestsignals basierend auf dem Phasenversatz, der von jeder Signalsequenz stammt und der erzeugt wird, nachdem die Signalsequenz den jeweiligen Kanal durchlaufen hat, um ein Zieltestsignal zu erhalten, das bei der Testvorrichtung phasengleich überlagert ist, wobei das Zieltestsignal mehrere Signalsequenzen umfasst, die durch separates Durchführen einer Phasenanpassung an dem Anfangstestsignal basierend auf dem Phasenversatz erhalten werden, der von jeder Signalsequenz stammt und der erzeugt wird, nachdem die Signalsequenz den jeweiligen Kanal durchlaufen hat; und
   Übertragen (305), durch die Sendevorrichtung, des Zieltestsignals durch Verwenden des Sendeantennenarrays, wobei eine Arrayapertur des Sendeantennenarrays, die als D bezeichnet wird, eine Entfernung zwischen dem Sendeantennenarray und einer Empfangsantenne, welche als d bezeichnet wird, und eine Wellenlänge des Zieltestsignals, die als λ bezeichnet wird, eine folgende Bedingung erfüllen:

   $$d < 2D^2/\lambda.$$

2. Verfahren nach Anspruch 1, wobei der Phasenversatz, das Anfangstestsignal und eine Signalsequenz des Zieltestsignals eine folgende Formel erfüllen:

   $$S_{tk} = S_t e^{-j\Delta\varphi_k},$$

   wobei
   $S_{tk}$ eine k-te Signalsequenz in dem Zieltestsignal ist, $S_t$ das Anfangstestsignal ist, $\Delta\varphi_k$ ein Phasenversatz ist, der von der k-ten Signalsequenz stammt und der erzeugt wird, nachdem die k-te Signalsequenz einen Kanal durchlaufen hat, und k nicht größer als N ist.

3. Verfahren nach Anspruch 1, wobei

   das Verfahren ferner Folgendes umfasst: Erhalten, durch die Sendevorrichtung von der Testvorrichtung, einer Abschwächungsamplitude, die von jeder Signalsequenz stammt und die erzeugt wird, nachdem die Signalsequenz einen jeweiligen Kanal durchlaufen hat; und
   das Anpassen (304), durch die Sendevorrichtung, eines Anfangstestsignals basierend auf dem Phasenversatz, der von jeder Signalsequenz stammt und der erzeugt wird, nachdem die Signalsequenz den jeweiligen Kanal durchlaufen hat, um ein Zieltestsignal zu erhalten, Folgendes beinhaltet: Anpassen, durch die Sendevorrichtung basierend auf dem Phasenversatz und der Abschwächungsamplitude, die von jeder Signalsequenz stammen und die erzeugt werden, nachdem die Signalsequenz den jeweiligen Kanal durchlaufen hat, des Anfangstestsignals, um das Zieltestsignal zu erhalten.

4. Verfahren nach Anspruch 3, wobei der Phasenversatz, die Abschwächungsamplitude, das Anfangstestsignal und eine Signalsequenz des Zieltestsignals eine folgende Formel erfüllen:

   $$S_{tk} = \frac{1}{\alpha_k} S_t e^{-j\Delta\varphi_k},$$

wobei

$S_{tk}$ eine k-te Signalsequenz in dem Zieltestsignal ist, $S_t$ das Anfangstestsignal ist, $\alpha_k$ die Abschwächungsamplitude ist, die von der k-ten Signalsequenz stammt und die erzeugt wird, nachdem die k-te Signalsequenz einen Kanal durchlaufen hat, $\Delta\varphi_k$ ein Phasenversatz ist, der von der k-ten Signalsequenz stammt und der erzeugt wird, nachdem die k-te Signalsequenz den Kanal durchlaufen hat, und k nicht größer als N ist.

5. Verfahren nach einem der Ansprüche 1 bis 4, wobei die N Signalsequenzen N Signalsequenzen sind, die aus einer orthogonalen Sequenz ausgewählt werden, und die orthogonale Sequenz eine m-Sequenz, eine Gold-Sequenz, eine Walsh-Sequenz, eine LAS-Sequenz, eine Golay-Sequenz oder eine Kasami-Sequenz ist.

6. Verfahren nach einem der Ansprüche 1 bis 4, wobei das Übertragen (301), durch eine Sendevorrichtung, von N Signalsequenzen durch Verwenden eines Sendeantennenarrays Folgendes umfasst:
gleichzeitiges Übertragen, durch die Sendevorrichtung, der N Signalsequenzen durch Verwenden des Sendeantennenarrays.

7. Verfahren nach einem der Ansprüche 1 bis 4, wobei das Übertragen (305), durch die Sendevorrichtung, des Zieltestsignals durch Verwenden des Sendeantennenarrays Folgendes umfasst:
gleichzeitiges Übertragen, durch die Sendevorrichtung, des Zieltestsignals durch Verwenden des Sendeantennenarrays, wobei das Zieltestsignal N Signalsequenzen umfasst.

8. Testverfahren, das Folgendes umfasst:

Empfangen (302), durch eine Testvorrichtung, eines ersten Signals durch Verwenden einer Empfangsantenne, wobei das erste Signal eine Kanalantwort von N Signalsequenzen ist, die durch eine Sendevorrichtung durch Verwenden eines Sendeantennenarrays gesendet werden, wobei die N Signalsequenzen orthogonal zueinander sind und N eine positive ganze Zahl größer als 1 ist,
Bestimmen, durch die Testvorrichtung basierend auf dem ersten Signal, eines Phasenversatzes, der von jeder Signalsequenz in den N Signalsequenzen stammt und der erzeugt wird, nachdem die Signalsequenz einen jeweiligen Kanal durchlaufen hat;
Senden, durch die Testvorrichtung an die Sendevorrichtung, des Phasenversatzes, der von jeder Signalsequenz stammt und der erzeugt wird, nachdem die Signalsequenz den jeweiligen Kanal durchlaufen hat;
Empfangen (306), durch die Testvorrichtung, eines zweiten Signals durch Verwenden der Empfangsantenne, wobei das zweite Signal eine Kanalantwort eines Zieltestsignals ist, das Zieltestsignal mehrere Signalsequenzen umfasst, die durch Anpassen, durch die Sendevorrichtung, eines Anfangstestsignals basierend auf dem Phasenversatz erhalten werden, der von jeder Signalsequenz stammt und der erzeugt wird, nachdem die Signalsequenz den jeweiligen Kanal durchlaufen hat, und das Zieltestsignal bei der Testvorrichtung phasengleich überlagert ist, und
Berechnen (307), durch die Testvorrichtung, eines Signalindikators der Sendevorrichtung basierend auf dem zweiten Signal,
wobei eine Arrayapertur des Sendeantennenarrays, die als D bezeichnet wird, eine Entfernung zwischen dem Sendeantennenarray und der Empfangsantenne, welche als d bezeichnet wird, und eine Wellenlänge des Zieltestsignals, die als $\lambda$ bezeichnet wird, eine folgende Bedingung erfüllen:

$$d < 2D^2/\lambda.$$

9. Verfahren nach Anspruch 8, wobei das Verfahren ferner Folgendes umfasst:

Bestimmen, durch die Testvorrichtung basierend auf dem ersten Signal, einer Abschwächungsamplitude, die von jeder Signalsequenz stammt und die erzeugt wird, nachdem die Signalsequenz einen jeweiligen Kanal durchlaufen hat, und
Senden, durch die Testvorrichtung an die Sendevorrichtung, der Abschwächungsamplitude, die von jeder Signalsequenz stammt und die erzeugt wird, nachdem die Signalsequenz den jeweiligen Kanal durchlaufen hat.

10. Sendevorrichtung (400), die Folgende umfasst:

ein Funkfrequenzmodul (401), das zum Übertragen von N Signalsequenzen durch Verwenden eines Sendeantennenarrays konfiguriert ist, wobei die N Signalsequenzen orthogonal zueinander sind, das Sendeantennenarray N Sendeantenneneinheiten umfasst und N eine positive ganze Zahl größer als 1 ist,
ein Erhaltemodul (402), das zum Erhalten, von einer Testvorrichtung, eines Phasenversatzes konfiguriert ist, der von jeder Signalsequenz in den N Signalsequenzen stammt und der erzeugt wird, nachdem die Signalsequenz einen jeweiligen Kanal durchlaufen hat; und

ein Anpassungsmodul (403), das zum Anpassen eines Anfangstestsignals basierend auf dem Phasenversatz konfiguriert ist, der von jeder Signalsequenz stammt und der erzeugt wird, nachdem die Signalsequenz den jeweiligen Kanal durchlaufen hat, um ein Zieltestsignal zu erhalten, das bei der Testvorrichtung phasengleich überlagert ist, wobei das Zieltestsignal mehrere Signalsequenzen umfasst, die durch separates Durchführen einer Phasenanpassung an dem Anfangstestsignal basierend auf dem Phasenversatz erhalten werden, der von jeder Signalsequenz stammt und der erzeugt wird, nachdem die Signalsequenz den jeweiligen Kanal durchlaufen hat; und

wobei das Funkfrequenzmodul (401) ferner zum Übertragen des Zieltestsignals durch Verwenden des Sendeantennenarrays konfiguriert ist,

wobei eine Arrayapertur des Sendeantennenarrays, die als D bezeichnet wird, eine Entfernung zwischen dem Sendeantennenarray und einer Empfangsantenne, welche als d bezeichnet wird, und eine Wellenlänge des Zieltestsignals, die als λ bezeichnet wird, eine folgende Bedingung erfüllen:

$$d < 2D^2/\lambda.$$

11. Sendevorrichtung (400) nach Anspruch 10, wobei der Phasenversatz, das Anfangstestsignal und eine Signalsequenz des Zieltestsignals eine folgende Formel erfüllen:

$$\boldsymbol{S_{tk}} = \boldsymbol{S_t} e^{-j\Delta\varphi_k},$$

wobei
$\boldsymbol{S_{tk}}$ eine k-te Signalsequenz in dem Zieltestsignal ist, $\boldsymbol{S_t}$ das Anfangstestsignal ist, $\Delta\varphi_k$ ein Phasenversatz ist, der von der k-ten Signalsequenz stammt und der erzeugt wird, nachdem die k-te Signalsequenz einen Kanal durchlaufen hat, und k nicht größer als N ist.

12. Sendevorrichtung (400) nach Anspruch 10, wobei

das Erhaltemodul (402) ferner zum Erhalten, von der Testvorrichtung, einer Abschwächungsamplitude konfiguriert ist, die von jeder Signalsequenz stammt und die erzeugt wird, nachdem die Signalsequenz einen jeweiligen Kanal durchlaufen hat; und
das Funkfrequenzmodul (401) ferner zum Anpassen des Anfangstestsignals basierend auf dem Phasenversatz und der Abschwächungsamplitude konfiguriert ist, die von jeder Signalsequenz stammen und die erzeugt werden, nachdem die Signalsequenz den jeweiligen Kanal durchlaufen hat, um das Zieltestsignal zu erhalten.

13. Sendevorrichtung (400) nach Anspruch 12, wobei der Phasenversatz, die Abschwächungsamplitude, das Anfangstestsignal und eine Signalsequenz des Zieltestsignals eine folgende Formel erfüllen:

$$\boldsymbol{S_{tk}} = \frac{1}{\alpha_k} \boldsymbol{S_t} e^{-j\Delta\varphi_k},$$

wobei
$\boldsymbol{S_{tk}}$ eine k-te Signalsequenz in dem Zieltestsignal ist, $\boldsymbol{S_t}$ das Anfangstestsignal ist, $\alpha_k$ die Abschwächungsamplitude ist, die von der k-ten Signalsequenz stammt und die erzeugt wird, nachdem die k-te Signalsequenz einen Kanal durchlaufen hat, $\Delta\varphi_k$ ein Phasenversatz ist, der von der k-ten Signalsequenz stammt und der erzeugt wird, nachdem die k-te Signalsequenz den Kanal durchlaufen hat, und k nicht größer als N ist.

14. Sendevorrichtung (400) nach einem der Ansprüche 10 bis 13, wobei das Funkfrequenzmodul (401) speziell zum gleichzeitigen Übertragen der N Signalsequenzen durch Verwenden des Sendeantennenarrays konfiguriert ist und die N Signalsequenzen orthogonal zueinander sind.

15. Sendevorrichtung (400) nach einem der Ansprüche 10 bis 13, wobei das Funkfrequenzmodul (401) speziell zum gleichzeitigen Übertragen des Zieltestsignals durch Verwenden des Sendeantennenarrays konfiguriert ist und das Zieltestsignal N Signalsequenzen umfasst.

**Revendications**

1. Procédé de test, comprenant :

   la transmission (301), par un dispositif émetteur, de N séquences de signal au moyen d'une antenne réseau de transmission, les N séquences de signal étant orthogonales entre elles, et N étant un entier positif supérieur à 1 ;
   l'obtention (303), par le dispositif émetteur, auprès d'un dispositif de test, d'un décalage de phase relatif à chaque séquence de signal des N séquences de signal et généré après le passage de la séquence de signal par un canal respectif ;
   l'ajustement (304), par le dispositif émetteur, d'un signal de test initial en fonction du décalage de phase relatif à chaque séquence de signal et généré après le passage de la séquence de signal par le canal respectif, pour obtenir un signal de test cible en phase superposé au niveau du dispositif de test, le signal de test cible comprenant une pluralité de séquences de signal obtenues par l'exécution séparément d'un ajustement de phase sur le signal de test initial en fonction du décalage de phase relatif à chaque séquence de signal et généré après le passage de la séquence de signal par le canal respectif ; et
   la transmission (305), par le dispositif émetteur, du signal de test cible au moyen de l'antenne réseau de transmission,
   une ouverture de réseau de l'antenne réseau de transmission, désignée D, une distance entre l'antenne réseau de transmission et une antenne de réception, désignée d, et une longueur d'onde du signal de test cible, désignée λ, satisfaisant à la condition suivante :

$$d = 2D^2/\lambda.$$

2. Procédé selon la revendication 1, dans lequel le décalage de phase, le signal de test initial et une séquence de signal du signal de test cible satisfont à la formule suivante :

$$\mathbf{S_{tk}} = \mathbf{S_t} e^{-j\Delta\varphi_k},$$

où
$\mathbf{S_{tk}}$ est une k$^{\text{ième}}$ séquence de signal dans le signal de test cible, $\mathbf{S_t}$ est le signal de test cible, $\Delta\varphi_k$ est un décalage de phase relatif à la k$^{\text{ième}}$ séquence de signal et généré après le passage de la k$^{\text{ième}}$ séquence de signal par un canal, et k n'est pas supérieur à N.

3. Procédé selon la revendication 1,

   lequel procédé comprend en outre : l'obtention, par le dispositif émetteur, auprès du dispositif de test, d'une amplitude d'atténuation relative à chaque séquence de signal et générée après le passage de la séquence de signal par un canal respectif ; et
   l'ajustement (304), par le dispositif émetteur, d'un signal de test initial en fonction du décalage de phase relatif à chaque séquence de signal et généré après le passage de la séquence de signal par le canal respectif, pour obtenir un signal de test cible, comprend : l'ajustement du signal de test initial, par le dispositif émetteur, en fonction du décalage de phase et de l'amplitude d'atténuation relatifs à chaque séquence de signal et générés après le passage de la séquence de signal par le canal respectif, pour obtenir le signal de test cible.

4. Procédé selon la revendication 3, dans lequel le décalage de phase, l'amplitude d'atténuation, le signal de test initial et une séquence de signal du signal de test cible satisfont à la formule suivante :

$$\mathbf{S_{tk}} = \frac{1}{\alpha_k} \mathbf{S_t} e^{-j\Delta\varphi_k},$$

où

$S_{tk}$ est une k$^{ième}$ séquence de signal dans le signal de test cible, $\mathbf{S_t}$ est le signal de test initial, $\alpha_k$ est l'amplitude d'atténuation relative à la k$^{ième}$ séquence de signal et générée après le passage de la k$^{ième}$ séquence de signal par un canal, $\Delta\varphi_k$ est un décalage de phase relatif à la k$^{ième}$ séquence de signal et généré après le passage de la k$^{ième}$ séquence de signal par un canal, et k n'est pas supérieur à N.

5. Procédé selon l'une quelconque des revendications 1 à 4, dans lequel les N séquences de signal sont N séquences de signal sélectionnées à partir d'une séquence orthogonale, et la séquence orthogonale est une séquence m, une séquence de Golden, une séquence de Walsh, une séquence LAS, une séquence de Golay, ou une séquence de Kasami.

6. Procédé selon l'une quelconque des revendications 1 à 4, dans lequel la transmission (301), par un dispositif émetteur, de N séquences de signal au moyen d'une antenne réseau de transmission, comprend :
la transmission simultanée, par le dispositif émetteur, des N séquences de signal au moyen de l'antenne réseau de transmission.

7. Procédé selon l'une quelconque des revendications 1 à 4, dans lequel la transmission (305), par le dispositif émetteur, du signal de test cible au moyen de l'antenne réseau de transmission, comprend :
la transmission simultanée, par le dispositif émetteur, du signal de test cible au moyen de l'antenne réseau de transmission, le signal de test cible comprenant N séquences de signal.

8. Procédé de test, comprenant :

la réception (302), par un dispositif de test, d'un premier signal au moyen d'une antenne de réception, le premier signal étant une réponse de canal de N séquences de signal envoyées par un dispositif émetteur au moyen d'une antenne réseau de transmission, les N séquences de signal étant orthogonales entre elles, et N étant un entier supérieur à 1 ;
la détermination, par le dispositif de test, en fonction du premier signal, d'un décalage de phase relatif à chaque séquence de signal des N séquences de signal et généré après le passage de la séquence de signal par un canal respectif ;
l'envoi, par le dispositif de test au dispositif émetteur, du décalage de phase relatif à chaque séquence de signal et généré après le passage de la séquence de signal par le canal respectif ;
la réception (306), par le dispositif de test, d'un deuxième signal au moyen de l'antenne de réception, le deuxième signal étant une réponse de canal d'un signal de test cible, le signal de test cible comprenant une pluralité de séquences de signal obtenues par ajustement, par le dispositif émetteur, d'un signal de test initial en fonction du décalage de phase relatif à chaque séquence de signal et généré après le passage de la séquence de signal par le canal respectif, et le signal de test cible étant en phase superposé au niveau du dispositif de test ; et
le calcul (307), par le dispositif de test, d'un indicateur de signal du dispositif émetteur en fonction du deuxième signal,
une ouverture de réseau de l'antenne réseau de transmission, désignée D, une distance entre l'antenne réseau de transmission et l'antenne de réception, désignée d, et une longueur d'onde du signal de test cible, désignée $\lambda$, satisfaisant à la condition suivante :

$$d = 2D^2/\lambda.$$

9. Procédé selon la revendication 8, lequel procédé comprend en outre :

la détermination, par le dispositif de test en fonction du premier signal, d'une amplitude d'atténuation relative à chaque séquence de signal et générée après le passage de la séquence de signal par un canal respectif ; et
l'envoi, par le dispositif de test au dispositif émetteur, de l'amplitude d'atténuation relative à chaque séquence de signal et générée après le passage de la séquence de signal par le canal respectif.

10. Dispositif émetteur (400), comprenant :

un module radiofréquence (401), configuré pour transmettre N séquences de signal au moyen d'une antenne réseau de transmission, les N séquences de signal étant orthogonales entre elles, l'antenne réseau de transmission comprenant N unités d'antenne de transmission, et N étant un entier supérieur à 1 ;

un module d'obtention (402), configuré pour obtenir, auprès d'un dispositif de test, un décalage de phase relatif à chaque séquence de signal des N séquences de signal et généré après le passage de la séquence de signal par un canal respectif ; et

un module d'ajustement (403), configuré pour ajuster un signal de test initial en fonction du décalage de phase relatif à chaque séquence de signal et généré après le passage de la séquence de signal par le canal respectif, pour obtenir un signal de test cible en phase superposé au niveau du dispositif de test, le signal de test cible comprenant une pluralité de séquences de signal obtenues par l'exécution séparément d'un ajustement de phase sur le signal de test initial en fonction du décalage de phase relatif à chaque séquence de signal et généré après le passage de la séquence de signal par le canal respectif ; et

le module radiofréquence (401) étant en outre configuré pour transmettre le signal de test cible au moyen de l'antenne réseau de transmission,

une ouverture de réseau de l'antenne réseau de transmission, désignée D, une distance entre l'antenne réseau de transmission et une antenne de réception, désignée d, et une longueur d'onde du signal de test cible, désignée $\lambda$, satisfaisant à la condition suivante :

$$d = 2D^2/\lambda.$$

**11.** Dispositif émetteur (400) selon la revendication 10, dans lequel le décalage de phase, le signal de test initial et une séquence de signal du signal de test cible satisfont à la formule suivante :

$$\mathbf{S_{tk}} = \mathbf{S_t}e^{-j\Delta\varphi_k},$$

où

$\mathbf{S_{tk}}$ est une k$^{\text{ième}}$ séquence de signal dans le signal de test cible, $\mathbf{S_t}$ est le signal de test cible, $\Delta\varphi_k$ est un décalage de phase relatif à la k$^{\text{ième}}$ séquence de signal et généré après le passage de la k$^{\text{ième}}$ séquence de signal par un canal, et k n'est pas supérieur à N.

**12.** Dispositif émetteur (400) selon la revendication 10, dans lequel

le module d'obtention (402) est en outre configuré pour obtenir, auprès du dispositif de test, une amplitude d'atténuation relative à chaque séquence de signal et générée après le passage de la séquence de signal par un canal respectif ; et

le module de radiofréquence (401) est en outre configuré pour ajuster le signal de test initial en fonction du décalage de phase et de l'amplitude d'atténuation relatifs à chaque séquence de signal et générés après le passage de la séquence de signal par le canal respectif, pour obtenir le signal de test cible.

**13.** Dispositif émetteur (400) selon la revendication 12, dans lequel le décalage de phase, l'amplitude d'atténuation, le signal de test initial et une séquence de signal du signal de test cible satisfont à la formule suivante :

$$\mathbf{S_{tk}} = \frac{1}{\alpha_k}\mathbf{S_t}e^{-j\Delta\varphi_k},$$

où

$\mathbf{S_{tk}}$ est une k$^{\text{ième}}$ séquence de signal dans le signal de test cible, $\mathbf{S_t}$ est le signal de test initial, $\alpha_k$ est l'amplitude d'atténuation relative à la k$^{\text{ième}}$ séquence de signal et générée après le passage de la k$^{\text{ième}}$ séquence de signal par un canal, $\Delta\varphi_k$ est un décalage de phase relatif à la k$^{\text{ième}}$ séquence de signal et généré après le passage de la k$^{\text{ième}}$ séquence de signal par un canal, et k n'est pas supérieur à N.

**14.** Dispositif émetteur (400) selon l'une quelconque des revendications 10 à 13, dans lequel le module radiofréquence (401) est spécifiquement configuré pour transmettre simultanément les N séquences de signal au moyen de l'antenne réseau de transmission, et les N séquences de signal sont orthogonales entre elles.

**15.** Dispositif émetteur (400) selon l'une quelconque des revendications 10 à 13, dans lequel le module radiofréquence (401) est spécifiquement configuré pour transmettre simultanément le signal de test cible au moyen de l'antenne réseau de transmission, et le signal de test cible comprend N séquences de signal.

FIG. 1

FIG. 2

A transmit device transmits N signal sequences by using a transmit antenna array — 301

A test device receives a first signal by using a receive antenna, where the first signal is a channel response of the N signal sequences — 302

The test device determines, based on the first signal, a phase offset that is of each signal sequence and that is generated after the signal sequence passes through a respective channel — 303

The transmit device adjusts an initial test signal based on the phase offset that is of each signal sequence and that is generated after the signal sequence passes through the respective channel, to obtain a target test signal — 304

The transmit device transmits the target test signal by using the transmit antenna array — 305

The test device receives a second signal by using the receive antenna, where the second signal is a channel response of the target test signal — 306

Calculate a signal indicator of the transmit device based on the second signal — 307

FIG. 3

FIG. 4

FIG. 5

600

```
┌─────────────────────────────────────────┐
│                                          │
│   ┌─────400         ┌─────500            │
│   ┌─────────────┐   ┌─────────────┐      │
│   │             │   │             │      │
│   │Transmit device│ │ Test device │      │
│   │             │   │             │      │
│   └──────┬──────┘   └──────┬──────┘      │
│          │                 │             │
│          └────────┬────────┘             │
│                                          │
│            MIMO test system              │
│                                          │
└─────────────────────────────────────────┘
```

FIG. 6

701                          700

```
   ▽
   │         ┌──────────────────────────┐
   │         │                          │703
   │         │      702                 │
   │    ┌────────────┐  ┌────────────┐  │
   └────│ Transmitter │──│  Processor │  │
        │            │  │            │  │
        └────────────┘  └─────┬──────┘  │
                              │         │704
                        ┌─────┴──────┐  │
                        │   Memory   │  │
        Transmit device │            │  │
                        └────────────┘  │
        └───────────────────────────────┘
```

FIG. 7

801   800

802   803

Receiver   Processor

804

Memory

Test device

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 101911655 A

- CN 102749529 A